# EUROPEAN PATENT APPLICATION

(11) **EP 0 996 161 A1**
(43) Date of publication of application: **26.04.2000**
(21) Application number: 98830627.0
(22) Date of filing: 20.10.1998
(51) Int. Cl.: H01L 27/115, H01L 21/8247

(54) **EEPROM with common control gate and common source for two cells**

(71) Applicant: STMicroelectronics S.r.l., 20041 Agrate Brianza (Milano) (IT)
(72) Inventor: Patelmo, Matteo, 20044 Bernareggio (IT); Dalla Libera, Giovanna, 20052 Monza (IT); Galbiati, Nadia, 20038 Seregno (IT); Vajana, Bruno, 24100 Bergamo (IT)
(74) Representative: Cerbaro, Elena, Dr.

(57) **Abstract**

The electronic device comprises pairs of memory cells (61a, 61b), formed in a same active area (9) of a substrate (2) of semiconductor material. Each cell is formed by a selection transistor (63a, 63b) and by a memory transistor (64a, 64b) of the floating gate and double polysilicon layer type. The memory transistors (64a, 64b) of the coupled cells have control gate regions formed by a single continuous gate region (43c) of semiconductor material extending over the respective floating gate regions (30a, 30b) and on the sides thereof which are reciprocally face-to-face, and on the zone of the substrate (2) accommodating a common source line (28).

## Description

The present invention relates to an electronic device comprising floating-gate nonvolatile memory cells of novel configuration.

As known, currently the electronics industry is increasingly miniaturizing electronic devices with the aim, inter alia, of reducing the total area occupied by the various components and, in particular, by the memory cells.

This trend also involves EEPROM cells each comprising a selection transistor in series with the memory element, below called memory transistor. Consequently, fabrication processes enabling the dimensions of memory cells to be reduced are being designed; the lithographic processes for defining the various regions of EEPROM cells do not, however, enable the dimensions of the cells to be reduced beyond a certain limit.

The object of the invention is therefore to provide a device comprising a nonvolatile EEPROM type memory of reduced size compared with current solutions.

The present invention provides an electronic device comprising floating-gate nonvolatile memory cells and the fabrication process thereof as defined in claims 1 and 8 respectively.

For understanding the present invention a preferred embodiment will now be described, purely by way of non-exhaustive example, with reference to the accompanying drawings, wherein:
- Figure 1 shows a cross-section of a silicon wafer in an initial phase of the process flow for obtaining the electronic device according to the invention;
- Figure 2 shows a top view of the wafer of Figure 1;
- Figures 3-4 show cross-sections similar to that of Figure 1, in subsequent fabrication phases;
- Figure 5 shows a top view of the wafer of Figure 4;
- Figure 6 shows a cross-section similar to that of Figure 4, in a subsequent fabrication phase;
- Figure 7 shows a top view of the wafer of Figure 6;
- Figure 8 shows a cross-section similar to that of Figure 6, in a subsequent fabrication phase;
- Figure 9 shows a top view of the wafer of Figure 8;
- Figures 10-11 show cross-sections similar to that of Figure 8, in subsequent fabrication phases;
- Figure 12 shows a top view of the wafer of Figure 11;
- Figures 13-14 show cross-sections similar to that of Figure 11, in subsequent fabrication phases;
- Figure 15 shows a top view of the wafer of Figure 14;
- Figures 16-17 show cross-sections similar to that of Figure 14, in subsequent fabrication phases;
- Figure 18 shows a top view similar to that of Figure 15, in a phase subsequent to Figure 17.

The following description relates, by way of example, to the fabrication of two pairs of memory cells, each formed by two EEPROM-type memory cells adjacent and coupled together, each cell comprising a selection transistor and a memory transistor.

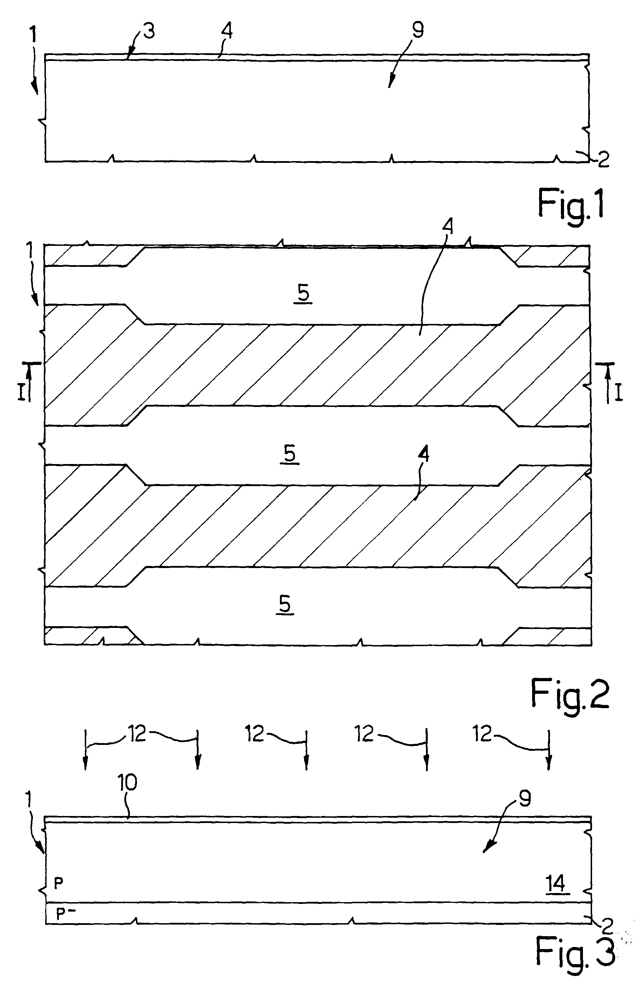

In Figure 1, in a wafer 1 formed by a substrate 2 of single-crystal silicon, P-type, the active areas have been already defined. In detail, with the surface 3 of the substrate 2 covered by an active area mask 4 of non-oxidizable material (typically formed by a double layer of silicon oxide and silicon nitride, defined through resist), the wafer 1 has been thermally oxidated; then, a thick oxide (field oxide 5, Figure 2) delimiting active area strips 9 intended to accommodate memory cells to be produced has been grown in the parts of the substrate 2 not covered by the active area mask 4.

In detail, portions of two active area strips 9 adjacent to each other and each intended to house a pair of cells (below also termed coupled cells), each comprising a selection transistor and a memory transistor, are visible in Figure 2. Further active areas (not shown) may generally be provided to produce LV or HV PMOS and NMOS transistors.

The active area mask 4 is then removed, the free surface 3 of the substrate is oxidated to form a sacrificial oxide layer 10 and P-type ionic dopants are implanted through a mask, as shown diagrammatically in Figure 3 by arrows 12. P-type wells 14 thus form in the substrate 2, at the active area strips 9, as shown in Figure 3.

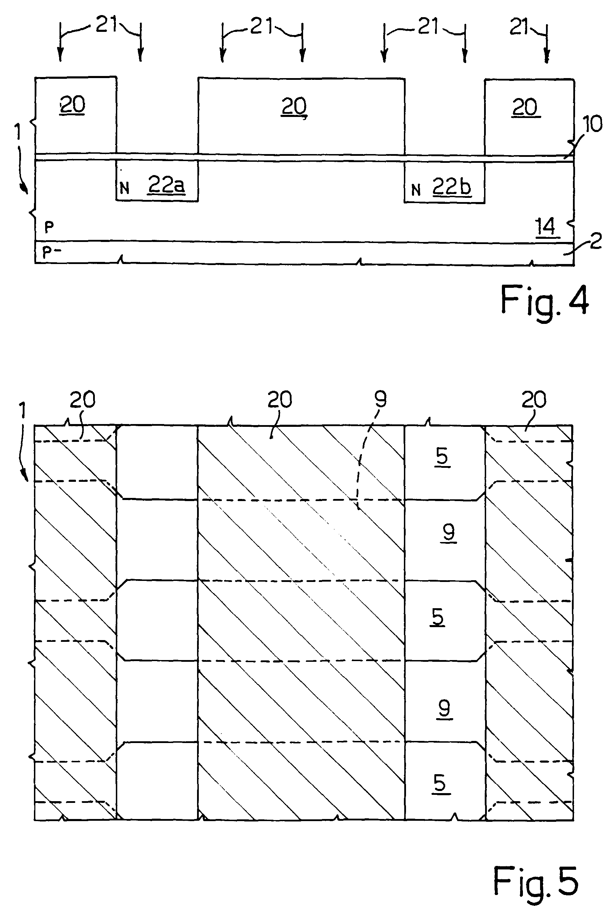

A capacitor mask 20 is then formed, covering the entire surface of wafer 1 apart from two strips perpendicular to the active area strips 9, as shown in cross-section in Figure 4 and in a top view in Figure 5. N-type dopants (such as phosphorus) are then implanted, as shown diagrammatically in Figure 5 by arrows 21. N-type continuity regions 22a and 22b, necessary for electrical continuity between each selection transistor and the associated memory transistor of each of the two coupled cells, are thus formed in the active area strips 9, as shown in Figure 5.

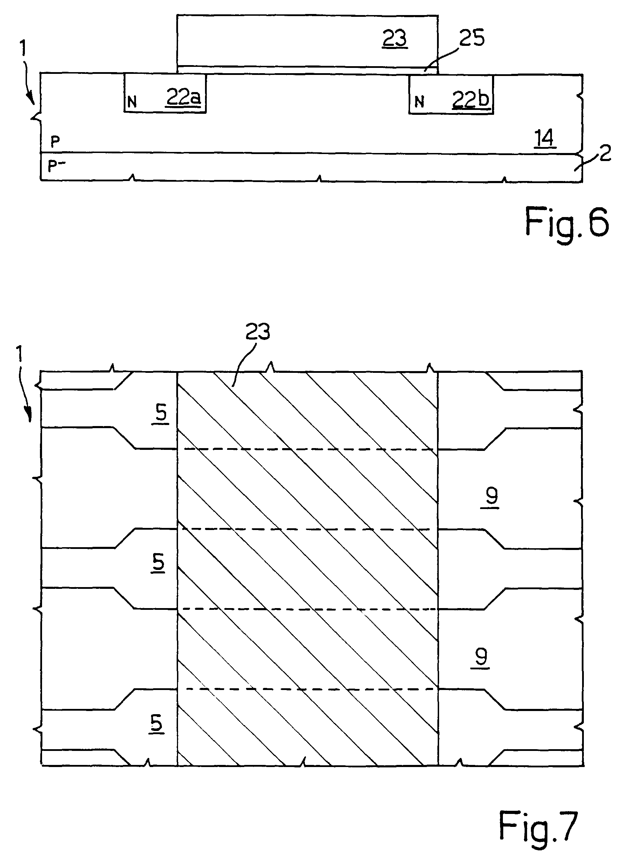

After removing capacitor mask 20, wafer 1 is annealed, sacrificial layer 10 is removed, and a matrix oxidation is carried out, for forming a matrix oxide layer on the exposed surface of substrate 2. Then, using a matrix oxide mask 23 shown in cross-section in Figure 6 and in a top view in Figure 7, the matrix oxide is removed where it is not masked, forming a matrix oxide region 25 (Figure 6) disposed partially on the continuity regions 22a and 22b.

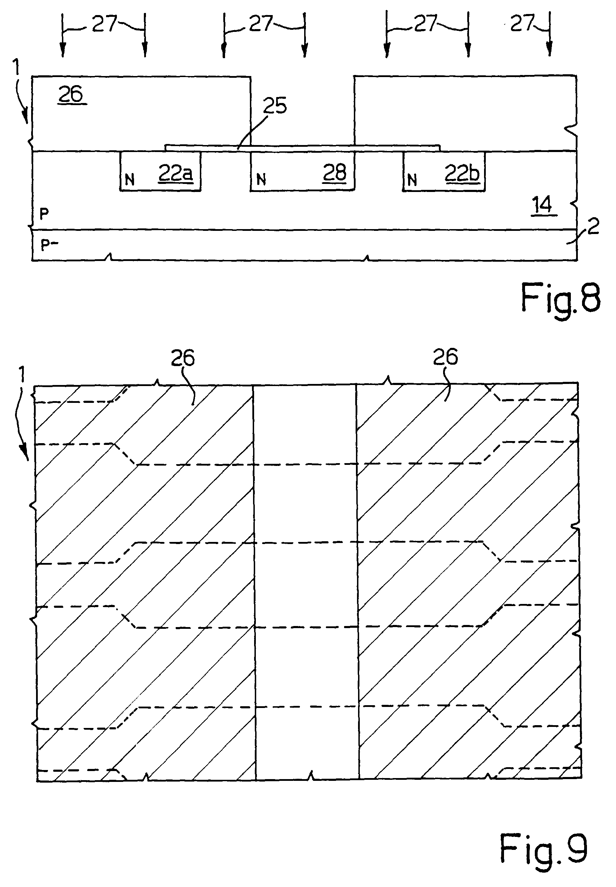

After removing the matrix oxide mask 23, a source mask 26 is formed covering the matrix zone as shown in cross-section in Figure 8 and in a top view in Figure 9, apart from where a source line, common to the two memory transistors of the coupled cells and to those adjacent (in the vertical direction with reference to Figure 9), is to be formed.

N-type dopants (such as phosphorus) are then implanted, as shown diagrammatically in Figure 8 by arrows 27. This implant passes beyond matrix oxide region 25 at the active area strips 9 and, laterally thereto, also the field oxide 5, to form a buried source line 28.

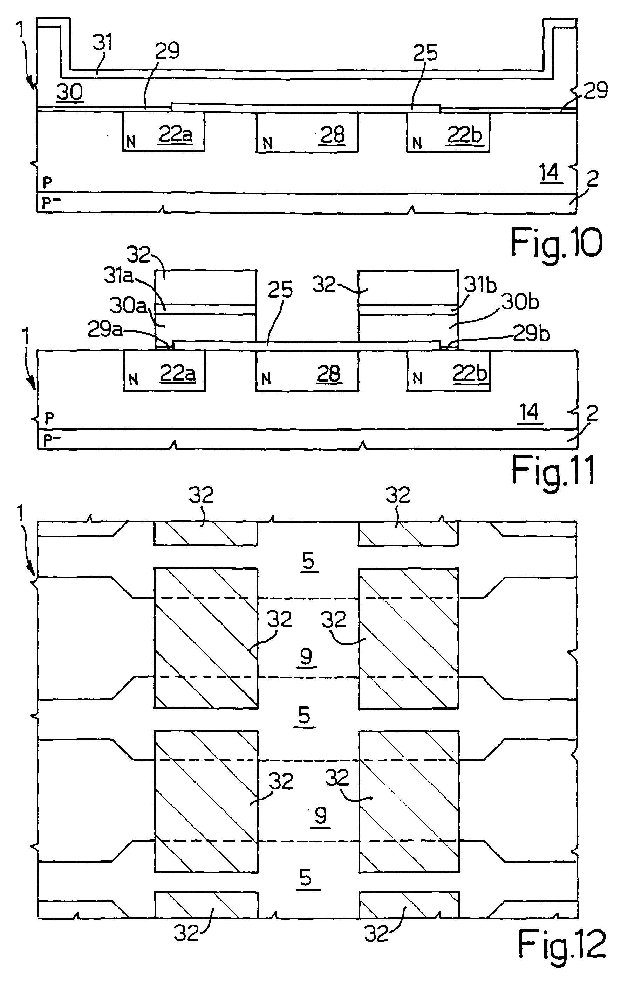

Wafer 1 is then oxidized again, forming a tunnel oxide layer 29 on the entire free surface of the active area. The matrix oxide region 25 increases in thickness in this step. Then, a first multi-crystal silicon layer (poly1 layer 30) is deposited and suitably doped and an interpoly dielectric layer 31, formed for example by a triple layer of ONO (silicon Oxide/silicon Nitride/silicon Oxide) is formed, as shown in Figure 10.

A floating-gate mask 32, shown in cross-section in Figure 11 and in a top view in Figure 12, is then formed and then the dielectric layer 31, the poly1 layer 30 and the tunnel oxide layer 29 are removed everywhere apart from where floating-gate and tunnel oxide regions of the memory transistors are to be formed. Consequently, floating-gate regions 30a and 30b and tunnel regions 29a and 29b are formed; in particular, as can be seen in Figure 11, the tunnel regions 29a and 29b of two cells coupled together are aligned with the respective floating-gate regions 30a and 30b on their sides not facing.

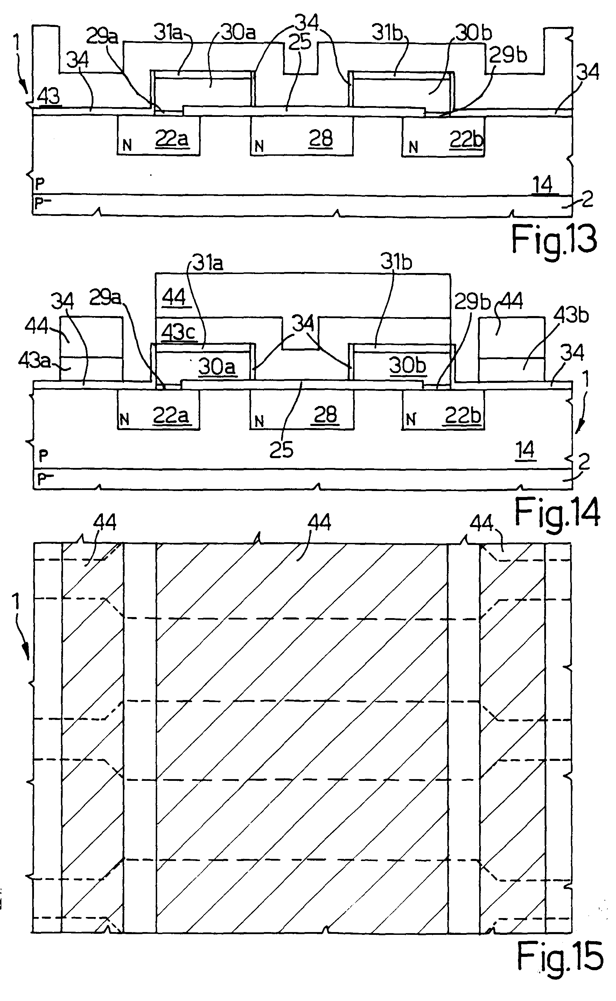

After removing the floating-gate mask 32, gate oxidation is carried out for forming a gate oxide layer 34 on the entire free surface of the substrate 2. Oxide portions 34 are also formed laterally on the floating-gate regions 30a and 30b of the memory transistors, as shown in Figure 13.

A second multi-crystal silicon layer (poly2 layer 43) is then deposited and doped as shown in Figure 13. A control gate mask 44 is then formed, covering poly2 layer 43 where the gate regions of the selection transistors and control gate regions of the memory transistors are to be defined, as shown in cross-section in Figure 14 and in a top view in Figure 15. The exposed portions of poly2 layer 43 are then removed, obtaining the intermediate structure of Figure 14 wherein the remaining portions of poly2 form a common gate region 43c defining both the control gate regions of the two cells belonging to the same pair and separate selection gate regions 43a and 43b of the selection transistors. Similarly to known devices, the strips forming the control gate regions (common gate regions 43c) are in common with the eight cells aligned in vertical direction (with reference to Figure 15) and are connected to respective switches (in a manner not shown).

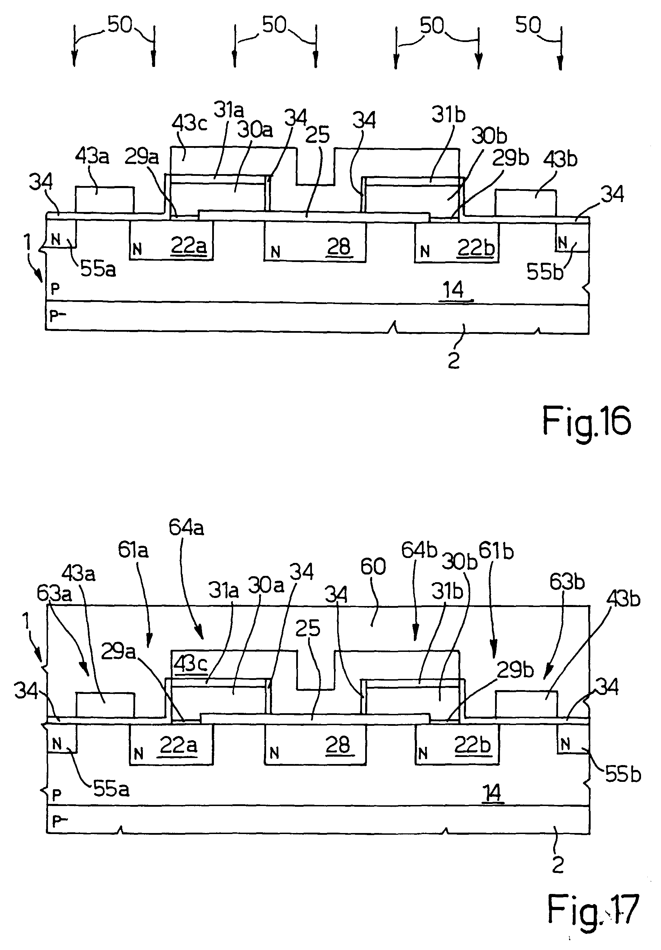

After removing control gate mask 44, N-type dopants are implanted (LDDN implant) as shown in diagrammatic form in Figure 16 by arrows 50. Drain regions 55a and 55b thus form at the sides of the selection gate regions 43a and 43b of the two cells belonging to the same pair; furthermore selection gate regions 43a and 43b and common gate region 43c are suitably doped. The structure of Figure 16 is thus obtained.

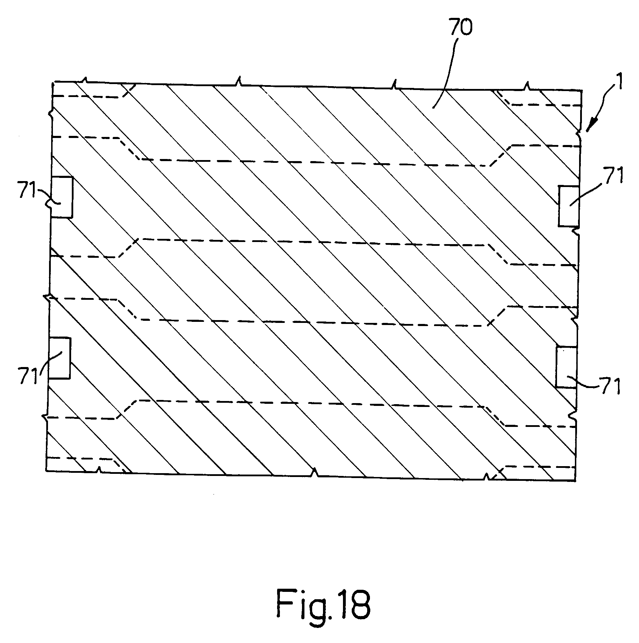

On the entire surface of the wafer 1 a protective dielectric layer 60 (for example TEOS-TetraEthylOrthoSilicate or nitride) is then deposited, obtaining the structure of Figure 17 showing two memory cells 61a and 61b, coupled together, each formed by a selection transistor 63a and 63b and a memory transistor 64a, 64b. In particular, the control gate regions of the memory transistors 64a, 64b are formed by a single silicon region 43c, shared with another seven pairs of cells disposed laterally to the pair shown in Figure 17 (before and/or behind the drawing plane). In practice, as can be seen in Figure 17, the common gate region 43c extends on laterally to floating gate regions 30a, 30b, on the reciprocally facing side; furthermore, the common gate region 43c extends on the buried source region 28 with no continuity solution.

The final steps follow, and include forming the contacts (as visible in Figure 18 showing a mask 70 with apertures 71 on drain regions 55a and 55b) and the electrical interconnection lines, depositing a passivation layer etc.

The pairs of memory cells 61a, 61b obtained in this way thus have a control gate region in common. This means that they may be erased only together whereas they may be written and read separately. Specifically, during writing, similarly to known EEPROM memory cells, The selection gate region of the cell to be written (such as the selection gate region 43a of cell 61a on the left of Figure 17) is biased at high voltage (typically greater than 12 V) just like the drain region 55a of the cell and the common gate region 43c is placed at low voltage (such as 0 V), causing electrons to be injected from the floating gate region 43a through the tunnel region 29a towards the continuity region 22a of the memory transistor 64a (writing of the cell 61a). In this step the selection gate region 43b of the cell 61b coupled with the cell to be written is not biased or is connected to ground (0 V); consequently, even if the high drain voltage is also present at the drain region 55b (connected to drain region 55a through the same bit line in a manner not shown but similar to known EEPROM memories), selection transistor 63b of the cell 61b is off and the respective memory transistor 64b is not written.

Similarly, during reading, if it is desired to read cell 61a, drain 55a, selection gate 43a, control gate 43c and source 28 regions are suitably biased, causing the reading of the only selected cell 61a.

Vice-versa, during erasing, the two coupled cells are erased simultaneously; applying a high voltage (typically higher than 12 V) to common control gate region 43c and to selection gate regions 43a, 43b and connecting the remaining regions to ground, electrons are injected into all the cells connected to the common control gate region and therefore to the eight pairs of cells forming two bytes.

In such devices the "granularity" is reduced from one byte to two. In practice, the device is no longer literally an EEPROM device, but may nonetheless be advantageously applied for applications using PEROM (Page Erasable ROM)-type devices, or memories erased by page (where each page comprises 32 or more bits). As is known, such applications currently use cells of traditional structure and, with respect to standard EEPROM applications, the software is modified for erasing.

In contrast the present device enables PEROM devices to be formed through a hardware structure instead of (purely) at software level. In this case erasing is also simplified and speeded up.

The thus obtained electronic device further has a reduced area because it is not necessary to space the two memory transistors by a quantity ensuring the physical and electrical separation of the control gate regions of two adjacent cells, also taking also account of the characteristics of the photolithographic process and the associated tolerances during the definition of the control gate regions. A further reduction in space is obtained because the switches for controlling the selection and control gate regions are brought close together, reducing a contact for each pair of bytes.

Furthermore, the cells obtained in this way have improved electrical performance, thanks to the larger facing surface between the common gate region 43c and each floating gate region 30a, 30b (which also comprises the reciprocally facing side of the floating gate regions 30a, 30b) and therefore to the obtainable greater capacitive coupling.

The described device has no technological critical factors (particularly lithographic) and it may be formed according to different processes of which the described one is solely an example.

Finally, the problems of defining the source line are avoided, as it is buried. The fabrication process further enables optimization of the number of device fabrication steps.

Finally, it will be clear that many modifications and variants may be introduced to the device and fabrication process described and illustrated herein, all of which come within the scope of the invention as defined in the accompanying claims. In particular, it is stressed that the principle of forming coupled memory cells having a common control gate region is also applicable to EEPROM devices that differ from that described and using different fabrication processes, suitably modifying the masks. In particular, for example, it should be noted that the source regions of the memory transistors may be formed in a different way from that described; for example, it is possible to use the traditional T-shape of the cells; then the active area mask is modified with respect to that shown to prevent the growth of field oxide in the portions of substrate accommodating the source lines (in per se known manner) or by selectively removing the field oxide before carrying out the source implant (also in per se known manner); alternatively, the implant of the source regions may be carried out simultaneously as the implant of the continuity regions 22, by suitably modifying the capacitor masks 20; optionally, if necessary, two different implant steps may be provided.

## Claims

1. An electronic device comprising at least a first (61a) and a second (61b) memory cell formed in the same active area (9) of a substrate (2) of semiconductor material;
each cell comprising a control gate region (43c) and a floating gate region (30a, 30b) both facing and insulated to each other by an insulating material layer (31a, 31b);
characterized in that said control gate regions (43c) of said first and the said second memory cell (61a, 61b) are formed by a common continuous gate region (43c) of semiconductor material.

2. An electronic device according to Claim 1, characterized in that said common continuous gate region (43c) comprises a first and a second portion and an intermediate portion between said first and second portion, said first and second portion extending over and on a reciprocally facing side of said floating gate regions (30a, 30b) of said first and second memory cell (61a, 61b) and said intermediate portion extending on said substrate (2) between said floating gate regions.

3. An electronic device according to Claim 2, characterized in that said substrate (2) has a first conductivity type and in that it comprises a conductive region (28) of a second conductivity type extending in said substrate under said intermediate portion of said common continuous gate region (43c).

4. An electronic device according to Claim 3, characterized in that said conductive region (28) is substantially aligned with said floating gate regions (30a, 30b).

5. An electronic device according to Claim 3 or 4, characterized by an insulating material layer (25) extending on said substrate (2) between said conductive region (28) and said common continuous gate region (43c).

6. An electronic device according to Claim 5, characterized in that said memory cells (61a, 61b) are EEPROM cells each comprising a selection transistor (63a, 63b) and a memory transistor (64a, 64b) and in that said common gate region (43c) forms control gate regions of the memory transistors (64a, 64b) of said EEPROM cells.

7. An electronic device according to Claim 6, characterized in that said insulating material layer (25) further extends continuously under a first part of said floating gate regions (30a, 30b) and has a first thickness; said insulating material layer being connected to insulating tunnel portions (29a, 29b) extending under a second part of said floating gate regions (30a, 30b) and having a second thickness smaller than the first thickness.

8. A process for fabricating electronic devices including the step of forming at least a first (61a) and a second (61b) memory cell, adjacent to each other, in a same active area (9) of a substrate (2) of semiconductor material,
said step of forming at least a first and a second memory cell comprising the steps of:
- forming at least one pair of floating gate regions (30a, 30b) on said substrate; and
- forming insulating regions (31a, 31b) adjacent to said floating gate regions;
characterized in that said step of forming at least a first and a second memory cell (61a, 61b) further comprises the step of:
- selectively forming a common continuous gate region (43c) facing and insulated from both said floating gate regions (30a, 30b).

9. A process according to Claim 8, characterized in that said step of forming a common continuous gate region (43c) comprises the step of forming a first and a second portion and an intermediate portion between said first and second portion, said first and second portion extending over and on a reciprocally facing side of said floating gate regions (30a, 30b) of said first and second cell (61a, 61b) and said intermediate portion extending on said substrate (2), between said floating gate regions.

10. A process according to Claim 8, characterized in that said substrate (2) has a first conductivity type and in that before said step of forming a common continuous gate region (43c), the step is carried out of forming a conductive region (28) of a second conductivity type in said substrate (2) in intermediate position between said floating gate regions (30a, 30b), in a position facing said intermediate portion of said common continuous gate region (43c).

11. A process according to Claim 10, characterized in that said conductive region (28) is formed substantially aligned with said floating gate regions (30a, 30b).

12. A process according to Claim 10 or 11, characterized in that said step of forming at least a first and a second memory cell (61a, 61b) comprises the steps of forming EEPROM cells each including at least one memory transistor (64a, 64b) and one selection transistor (63a, 63b) and in that said common continuous gate region (43c) forms control gate regions of the memory transistors (64a, 64b) of said EEPROM cells.

13. A process according to Claim 12, characterized in that before said step of forming at least one pair of floating gate regions (30a, 30b), the steps are carried out of forming an insulating matrix region (25) on said substrate (2) and forming insulating tunnel regions (29a, 29b), laterally to said insulating matrix region (25), in that said floating gate regions (30a, 30b) are formed on said insulating tunnel regions (29a, 29b) and in part on said insulating matrix region (25), and in that said intermediate portion of said common continuous gate region (43c) is formed on said insulating matrix region (25).
